**Europäisches Patentamt**

**European Patent Office**

**Office européen des brevets**

(19)

(11) Publication number: **0 303 390 B1**

(12) # EUROPEAN PATENT SPECIFICATION

(45) Date of publication of the patent specification:
31.10.90

(51) Int. Cl.⁵: **H01L 21/78, H01L 29/90**

(21) Application number: 88307157.3

(22) Date of filing: 03.08.88

(54) **Manufacture of diodes.**

(30) Priority: 14.08.87 GB 8719309

(43) Date of publication of application:
15.02.89 Bulletin 89/7

(45) Publication of the grant of the patent:
31.10.90 Bulletin 90/44

(84) Designated Contracting States:
DE FR

(56) References cited:
EP-A- 0 085 607
FR-A- 2 538 616

(73) Proprietor: **MARCONI ELECTRONIC DEVICES LIMITED,**
**The Grove Warren Lane, Stanmore Middlesex**
**HA7 4LY(GB)**

(72) Inventor: **Dale, Ian, 14 Sycamore Close, Branston**
**Lincoln. LN4 1QG(GB)**
Inventor: **Mitchell, Alistair, 62 Colonial Avenue Whitton,**
**Twickenham Middlesex(GB)**

(74) Representative: **Hoste, Colin Francis, The General**
**Electric Company p.l.c. Central Patent Department**
**(Wembley Office) Hirst Research Centre East Lane,**
**Wembley Middlesex, HA9 7PP(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a method of manufacturing diodes and in particular to a method of manufacturing diodes comprising a region of intrinsic material between highly doped p-type and n-type layers to form a PIN diode.

When there is no bias applied to a PIN diode, the intrinsic region is empty of tree charges. However, when the device is forward-biased, electrons from the n-type layer flow into the intrinsic region thus lowering the AC resistance of the device. In this way, as the DC current through the device increases, the AC resistance decreases.

It is known to manufacture PIN diodes by diffusing p-type material into one surface and n-type material into the opposite surface of a thin slice of intrinsic silicon. Conventional PIN diodes have an intrinsic region of thickness 5 to 10 μm. It is difficult to reduce the width of the intrinsic region of a diode made by presently-known techniques without impairing the quality of the intrinsic material; the transition regions become less abrupt and impurities diffuse into the intrinsic region.

It is an object of this invention to provide a method of manufacturing very thin PIN diodes whilst preserving the properties of the intrinsic material.

According to the invention, a method of manufacturing a plurality of diodes comprises the steps of introducing a dopant of a first conductivity type into one surface of a layer of intrinsic material; growing a layer of supporting material onto the surface into which the dopant of said first conductivity type was introduced; introducing a dopant of a second conductivity type into the other surface of the layer of intrinsic material; and subsequently dividing the layer of intrinsic material into individual elements each of which constitutes a diode.

Each resulting diode is therefore a PIN (or a NIP) diode in which the purity of the middle layer of intrinsic semiconductor material is preserved. As the intrinsic semiconductor material is supported by the supporting material, the intrinsic semiconductor material can be a very thin and fragile wafer or slice.

Preferably a coating of a passivation material is formed on the surface of the intrinsic material where the layer of supporting material is to be grown.

The coating of passivation material preferably comprises a layer of silicon dioxide overlaid with a layer of silicon nitride.

The supporting material is preferably formed of polysilicon or of any grown material, provided that the material would not damage the intrinsic layer (e.g. by transfer of dopants). It acts to strengthen the substrate and facilitates the handling of the device during the manufacturing process. The material used should be capable of withstanding high temperatures and should have a temperature coefficient of expansion compatible with that of the semiconductor material. The intrinsic layer may then be thinned to a degree which is not practicable using other methods of manufacture, to produce a very thin device.

After the intrinsic layer has been thinned, additionally removing any semiconductor material into which dopants of said first conductivity type have been introduced, to expose the surface of the intrinsic layer, dopants of a second conductivity type may be diffused into the exposed surface.

The surface of the intrinsic layer into which the dopants of the second conductivity type are diffused may be masked. A mesa structure for the device can then be formed by etching through the intrinsic layer as far as the supporting layer.

Conveniently, the masking layer is removed and further coatings of silicon oxide and silicon nitride are formed, for passivation. A further glass passivating layer may be formed over the oxide and nitride coatings.

In order to make an electrical contact, the passivation coatings covering the semiconductor layer, into which dopants of said second conductivity type have been introduced, may be at least partially removed to expose the surface of the said semiconductor layer. A metal contact may then be formed on the exposed surface.

After this, the supporting material is conveniently etched away, having mounted the wafer on a ceramic carrier using wax. The exposed areas of the passivation coating may then be removed also by etching so as to expose the semiconductor material doped with dopants of said first conductivity type. The exposed material is coated with metal to form the other diode contact.

The other side of the semiconductor material doped with dopants of said first conductivity type is preferably plated with metal to form a base which acts as an integral heat sink. As the thermal paths to the heat sink are thus very short, this improves the power handling of the device.

If the semiconductor materials used are highly doped, this improves the quality of the ohmic contacts.

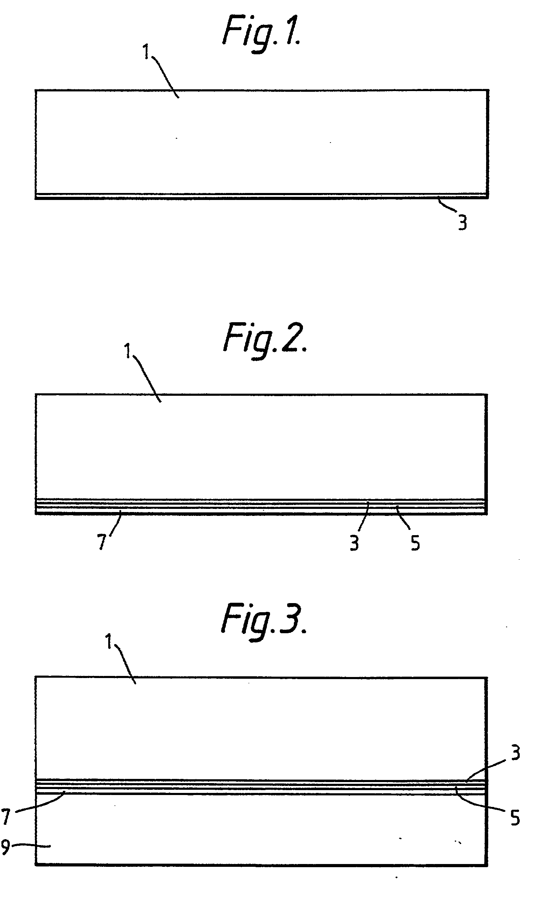

A method of manufacturing diodes in accordance with the invention will now be described, by way of example only, with reference to Figures 1 to 11.

In Figure 1, a 2μm layer 3 of heavily doped p-type silicon is formed by diffusing boron into a 250 μm substrate 1 of intrinsic silicon. Using a Silox process a 0.1 μm coating 5 of silicon dioxide is deposited onto the diffused surfaces followed by a 0.2 μm coating 7 of silicon nitride deposited by chemical vapour deposition (Figure 2), to form passivation coatings.

Figure 3 shows a 125 μm supporting layer 9 of polysilicon which is grown on top of the nitride coating 7 by chemical vapour deposition.

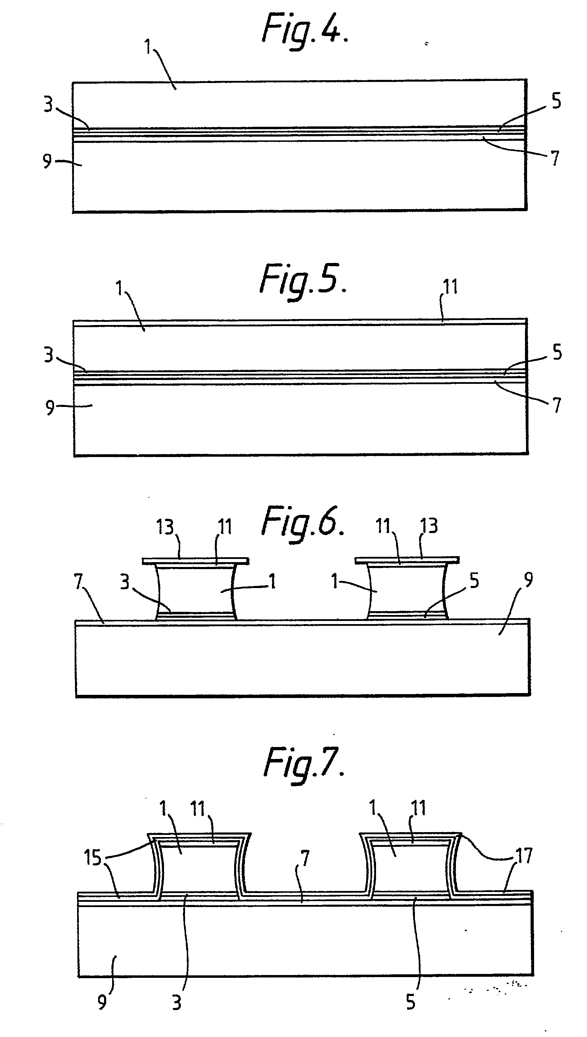

The intrinsic silicon substrate 1 is the thinned (Figure 4) to the required final thickness, which is of the order of 5μm, using a mixture of nitric acid, hydrogen fluoride and ethanoic acid. Phosphorus is then diffused into the exposed surface of the substrate to form an n-type layer 11 (Figure 5).

A masking layer 13 is placed onto the substrate 1 (Figure 6) and a mesa structure is formed by etching through the silicon as far as the nitride coating 7.

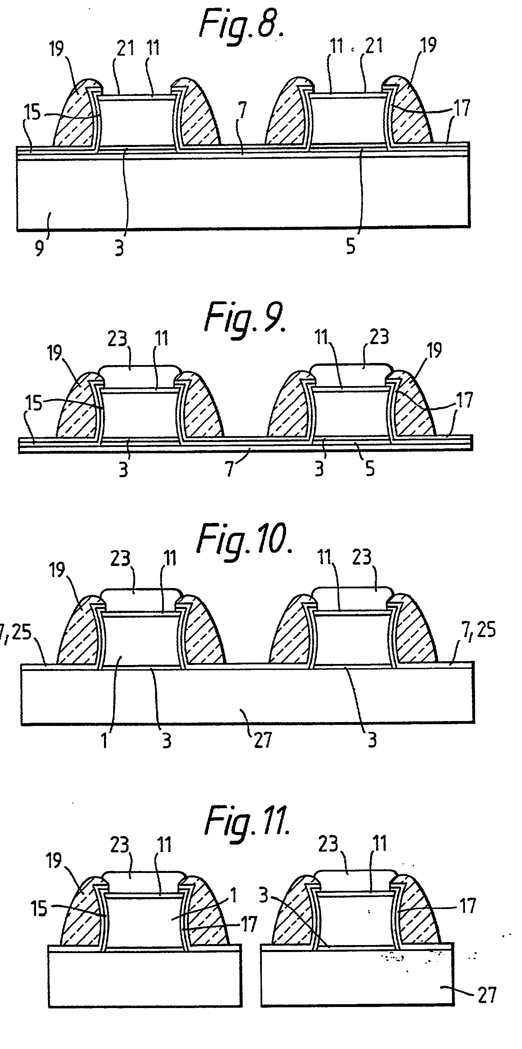

As shown in Figure 7, the masking layer 13 is then removed and a passivation coating of silicon oxide 15 and silicon nitride 17 is deposited, followed by a further passivating coating of glass 19. Parts of the passivation coating (15, 17, 19) are removed to make a top contact 21 (Figure 8). This contact 21 is then covered with a layer of metal 23. In Figure 9, the substrate is mounted on a ceramic carrier (not shown) using wax and the polysilicon supporting layer 9 is etched away.

Figure 10 shows the substrate with the exposed silicon nitride 7 and silicon dioxide 5 removed so as to open up the second diode contact 25. The silicon nitride is plasma etched with $CF_4:O_2$ in the ratio 9:1. Buffered HF is used to etch the silicon dioxide layer. The second contact 25 is also metalised by evaporating a layer of titanium silver 27, onto the surface and covering the base of the wafer. The area is then plated with silver to a thickness of approximately $10\text{-}20\mu m$. The top of the contact is then defined in photoresist and etched with a mixture of ammonium hydroxide, hydrogen peroxide and water.

The individual diodes may then be separated (Figure 11) by sawing through the metalised base layer 27.

## Claims

1. A method of manufacturing a plurality of PIN diodes comprises the steps of introducing a dopant of a first conductivity type into one surface of a layer of intrinsic material; growing a layer of supporting material onto the surface into which the dopant of said first conductivity type was introduced; thinning the layer of intrinsic material by removing material from its other surface; introducing a dopant of a second conductivity type into the other surface of the layer of intrinsic material; removing said supporting material; and subsequently dividing the layer of intrinsic material into individual elements, each of which constitutes a diode.

2. A method of manufacturing a plurality of diodes as claimed in Claim 1 wherein a coating of passivation material is formed on the surface of the intrinsic material where the layer of supporting material is to be grown.

3. A method of manufacturing a plurality of diodes as claimed in Claim 2 wherein the coating of passivation material comprises silicon nitride.

4. A method of manufacturing a plurality of diodes as claimed in Claim 2 or 3 wherein the coating of passivation material comprises silicon dioxide.

5. A method of manufacturing a plurality of diodes as claimed in any preceding claim wherein the supporting material is polysilicon.

6. A method of manufacturing a plurality of diodes as claimed in any preceding claim wherein the supporting material is removed before the layer of intrinsic material is divided.

7. A method of manufacturing a plurality of diodes as claimed in Claim 6, wherein the passivation coating on the surface of the intrinsic material, doped with a dopant of said first conductivity type, is removed before the layer of intrinsic material is divided.

8. A method of manufacturing a plurality of diodes as claimed in Claim 7 wherein the layer of intrinsic material is metalised after the removal of the passivation coating.

## Patentansprüche

1. Verfahren zum Herstellen mehrerer PIN-Dioden, aufweisend die Schritte des Einbringens eines Dotierungsstoffs einer ersten Leitfähigkeitsart in eine Oberfläche einer Schicht eines Intrinsic-Materials; Aufwachsens einer Trägermaterialschicht auf der Oberfläche, in die der Dotierungsstoff der ersten Leitfähigkeitsart eingebracht wurde; Verdünnens der Intrinsic-Materialschicht durch Entfernen von Material von deren anderer Oberfläche; Einbringens eines Dotierungsstoffs einer zweiten Leitfähigkeitsart in die andere Oberfläche der Intrinsic-Materialschicht; Entfernens des Trägermaterials; und des darauffolgenden Teilens der Intrinsic-Materialschicht in einzelne Elemente, von denen jedes eine Diode darstellt.

2. Verfahren zum Herstellen mehrerer Dioden nach Anspruch 1, in welchem eine Beschichtung aus Passivierungsmaterial auf der Oberfläche des Intrinsic-Materials, dort, wo die Trägermaterialschicht aufzuwachsen ist, ausgebildet wird.

3. Verfahren zum Herstellen mehrerer Dioden nach Anspruch 2, in welchem die Passivierungsmaterialbeschichtung Siliciumnitrid umfaßt.

4. Verfahren zum Herstellen mehrerer Dioden nach Anspruch 2 oder 3, in welchem die Passivierungsmaterialbeschichtung Siliciumdioxid umfaßt.

5. Verfahren zum Herstellen mehrerer Dioden nach einem der vorstehenden Ansprüche, in welchem das Trägermaterial Polysilicium ist.

6. Verfahren zum Herstellen mehrerer Dioden nach einem der vorstehenden Ansprüche, in welchem das Trägermaterial entfernt wird, bevor die Intrinsic-Materialschicht zerteilt wird.

7. Verfahren zum Herstellen mehrerer Dioden nach Anspruch 6, in welchem die Passivierungsbeschichtung auf der Oberfläche des Intrinsic-Materials, die mit einem Dotierungsstoff der ersten Leitfähigkeitsart dotiert ist, entfernt wird, bevor die Intrinsic-Materialschicht zerteilt wird.

8. Verfahren zum Herstellen mehrerer Dioden nach Anspruch 7, in welchem die Intrinsic-Materialschicht nach dem Entfernen der Passivierungsbeschichtung metallisiert wird.

## Revendications

1. Procédé de fabrication de plusieurs diodes de type "PIN" (dopage positif/matière intrinsèque non dopée/dopage négatif), comprenant les étapes consistant à introduire une matière dopante, ou dope, d'un premier type de conductivité dans une surface d'une couche de matière intrinsèque; à faire croître une couche de matière de support sur la surface dans laquelle le dope d'un premier type de conductivité a été introduit; à amincir la couche de matière intrinsèque en enlevant de la matière de son autre surface; à introduire un dope d'un second type de conductivité dans l'autre surface de la couche de matière intrinsèque; à enlever ladite matière de support; et à diviser ensuite la couche de matière intrinsèque en les éléments individuels, dont chacun constitue une diode.

2. Procédé de fabrication de plusieurs diodes selon la revendication 1, dans lequel un revêtement de matière de passivation est formé à la surface de la matière intrinsèque où l'on doit faire croître la couche de matière de support.

3. Procédé de fabrication de plusieurs diodes selon la revendication 2, dans lequel le revêtement en matière de passivation est constitué par, ou comprend, du nitrure de silicium.

4. Procédé de fabrication de plusieurs diodes selon la revendication 2 ou 3, dans lequel le revêtement en matière de passivation est constitué par, ou comprend, du bioxyde de silicium.

5. Procédé de fabrication de plusieurs diodes selon l'une quelconque des revendications précédentes, dans lequel la matière de support est du silicium polycristallin ("polysilicium").

6. Procédé de fabrication de plusieurs diodes selon l'une quelconque des revendications précédentes, dans lequel la matière de support est enlevée avant division de la couche de matière intrinsèque.

7. Procédé de fabrication de plusieurs diodes selon la revendication 6, dans lequel le revêtement de passivation à la surface de la matière intrinsèque, dopée par un dope dudit premier type de conductivité, est enlevé avant division de la couche de matière intrinsèque.

8. Procédé de fabrication de plusieurs diodes selon la revendication 7, dans lequel la couche de matière intrinsèque est métallisée après enlèvement du revêtement de passivation.

## Fig.1.

1

3

## Fig.2.

1

7    3    5

## Fig.3.

1

3

7

5

9

EP 0 303 390 B1

# Fig.4.

# Fig.5.

# Fig.6.

# Fig.7.

Fig.8.

Fig.9.

Fig.10.

Fig.11.